# EUROPÄISCHE PATENTSCHRIFT

(11) **EP 4 148 510 B1**
(45) Veröffentlichungstag und Bekanntmachung des Hinweises auf die Patenterteilung: **04.03.2026**
(21) Anmeldenummer: 21195609.9
(22) Anmeldetag: 08.09.2021
(51) Int. Cl.: G05B 19/042, G05B 23/02, H02H 11/00, H02J 1/00

(54) **VERFAHREN ZUM ÜBERWACHEN UND STEUERN EINER STROMVERTEILUNG IN EINER ANLAGE**
METHOD FOR MONITORING AND CONTROLLING A CURRENT DISTRIBUTION IN A SYSTEM
PROCÉDÉ DE SURVEILLANCE ET DE COMMANDE D'UNE DISTRIBUTION DE COURANT DANS UNE INSTALLATION

(43) Veröffentlichungstag der Anmeldung: 15.03.2023
(73) Patentinhaber: Siemens Aktiengesellschaft, 80333 München (DE)
(72) Erfinder: Czech, Silvan, 91058 Erlangen (DE); Kogard, Markus, 2102 Hagenbrunn (AT); Paul, Wolfgang, 2344 Maria Enzersdorf (AT); Schweigert, Harald, 1120 Wien (AT)
(74) Vertreter: Siemens Patent Attorneys

(56) Entgegenhaltungen:
- WO-A1-2010/018018
- WO-A1-2019/162750

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf ein Verfahren zum Überwachen und Steuern einer Stromverteilung in Lastkreisen einer Anlagensteuerung einer technischen Anlage. Die Lastkreise weisen dabei zumindest eine Lasteinheit (z.B. Sensor, Aktor, Relais, Schütz, Magnetventil, Stellmotor, Steuerung, Anzeigeeinheit, etc.) auf. Von zumindest einer getakteten Stromversorgungseinheit wird eine zumeist vorgegebene und konstante Ausgangsspannung zur Verfügung gestellt und für eine Energieversorgung der Lasteinheiten auf die Lastkreise der Anlagensteuerung aufgeteilt. Weiterhin ist zumindest eine Mehrzahl der Lastkreise durch eine Schaltereinheit abgesichert, welche durch eine Steuereinheit angesteuert wird.

### Stand der Technik

In vielen Bereichen, vor allem in der industriellen Produktion und Fertigung, in der Automatisierungstechnik, etc., kommen heutzutage komplexe, technische Anlagen und Maschinen zum Einsatz. Unter einer Anlage wird dabei eine planvolle Zusammenstellung von Komponenten z.B. Maschinen, Geräten und/oder Apparaten) verstanden, welche in einem räumlichen Zusammenhang stehen und funktional, steuerungstechnisch und/oder sicherheitstechnisch miteinander verknüpft sind. Für einen effizienten Betrieb von technischen Anlagen werden üblicherweise Anlagensteuerung eingesetzt, durch welche ein laufender Betrieb der Anlage möglichst selbständig und unabhängig von menschlichen Eingriffen erfolgen soll. Da technische Anlagen wie z.B. Produktionsanlagen, Fertigungsanlagen, etc. aufgrund unterschiedlicher Anforderungen nur sehr selten baugleich ausgeführt sind, umfasst daher jede Anlage bzw. die jeweils zugehörige Anlagensteuerung unterschiedlich viele und unterschiedlich große Verbraucher bzw. Lasteinheiten - wie z.B. Aktoren, Relais, Schütze, Magnetventile, Stellmotoren, akustische und/optische Warnsignale, Sensoren, etc. sowie Steuerungen (z.B. speicherprogrammierbare Steuerung (SPS), PCbasierte Steuerung, Mikrocontroller, etc.) für z.B. eine Auswertung von Sensorwerten und/oder eine Ansteuerung von Aktoren, etc. und Anzeigeeinheiten.

In der Regel werden bei technischen Anlagen mehrere elektrische Lasteinheiten der Anlagensteuerung zu Versorgungssektoren bzw. Lastkreisen zusammengefasst, wobei ein Lastkreis zumindest eine Lasteinheit (z.B. Sensoren, Aktoren, Steuerung, Anzeigeeinheiten, etc.) aufweist. Zur Energieversorgung der in Lastkreisen angeschlossenen Lasteinheiten wird üblicherweise zumindest ein getaktete Stromversorgungseinheit (z.B. Schaltnetzteil) eingesetzt. Durch die getaktete Stromversorgungseinheit wird eine unstabilisierte Eingangsspannung - meist eine Wechselspannung - in eine konstante Ausgangsspannung mit einem zumeist vorgegebenen Wert (z.B. 24 Volt Gleichspannung) umgesetzt. Die von der getakteten Stromversorgungseinheit zur Verfügung gestellte Ausgangsspannung bzw. der zur Verfügung gestellte Ausgangsstrom wird dann auf die jeweiligen Lastkreise der Anlagensteuerung der technischen Anlage aufgeteilt, wobei die einzelnen Lastkreise bzw. die jeweils angeschlossenen Lasteinheiten unterschiedlichen Strombedarf aufweisen können.

Störungen von Lasteinheiten können allerdings Rückwirkungen auf die Stromversorgungseinheit bewirken. So kann z.B. eine Überlast, ein Kurzschlussfall oder ein kurzschlussähnlicher Überstrom, wie er beispielsweise beim Anlauf von Motoren durch einen hohen Strombedarf entsteht, in einem Lastkreis ein Abschalten der Stromversorgungseinheit initiieren. Um einen Totalausfall der Anlage durch z.B. ein Abschalten der Stromversorgungseinheit zu verhindern, werden die Lastkreise meist ausgangsseitig der Stromversorgungseinheit mit Schutzeinrichtungen gegen Überlasten oder Kurzschlüsse, wie z.B. Leitungsschutzschaltern bzw. Sicherungsautomaten mit bestimmter Auslösecharakteristik, abgesichert. Dadurch wird zwar sichergestellt, dass ein überlasteter Lastkreis abgeschaltet wird und dass die restlichen Lastkreise der Anlage bzw. Anlagensteuerung hiervon unbeeinflusst bleiben. Allerdings weisen insbesondere Schutzeinrichtungen wie Leistungsschutzschalter, welche zwar kostengünstig sind, bei der Auslösegenauigkeit große Toleranzen auf. Im Fehlerfall kann es daher zu Verzögerungen (z.B. einige Millisekunden) bei der Auslösung kommen.

Daher werden heutzutage zur Absicherung von getakteten Stromversorgungseinheiten vor Rückwirkungen aus Lastkreisen (z.B. defekte Lasteinheit, Kurzschluss, kurzschlussähnlicher Überstrom, Überlast, etc.) immer häufiger elektronische Sicherungen eingesetzt. Derartige Sicherungen weisen eine elektronische Schaltereinheit (z.B. Halbleiterschalter) auf, welche durch entsprechende Steuersignale einer Steuereinheit angesteuert wird. Derartige Sicherungen können im Fehlerfall schnell eingreifen und entsprechend der mittels der Steuereinheit einstellbaren Auslöseparameter (z.B. Auslösestrom, maximal zulässig Dauer eines Überstroms, etc.) einen Strom im entsprechenden Lastkreis begrenzen und/oder abschalten, wenn ein Überschreiten eines der einstellbaren Auslöseparameter festgestellt wird.

Eine Dimensionierung der Absicherung einzelner Lastkreise bzw. der daran angeschlossenen Lasteinheiten wird üblicherweise in einer Projektierungsphase einer Anlage festgelegt, während einer Realisierungsphase der Anlage eingestellt und kann z.B. während einer Erstinbetriebnahme der Anlage noch angepasst werden, wobei in erster Linie zu gering dimensionierte bzw. eingestellte Sicherungen nachjustiert werden. Häufig werden allerdings aus Zeitgründen die Auslöseparameter der Sicherungen der einzelnen Lastkreise nicht geeignet ausgewählt. D.h., es werden z.B. zu hoch gewählte Auslöseparameter bei der Sicherung bzw. der Schaltereinheit eingestellt als für den jeweiligen Lastkreis bzw. die jeweilige, zumindest eine angeschlossene Lasteinheit notwendig wäre.

Eine selektive Auslösung einzelner Sicherungen bzw. Schaltereinheiten ist damit nicht mehr gewährleistet, weil im Fehlerfall (z.B. Kurzschluss, Überlast, etc.) die direkt vor dem betroffenen Lastkreis angeordnete - zu hoch dimensionierte - Schaltereinheit von der Steuereinheit nicht mehr rechtzeitig angesteuert wird, um den Strom zu begrenzen und/oder zu unterbrechen. Der Strom kann damit in den betroffenen Lastkreis und damit in die zumindest eine Lasteinheit des Lastkreises fließen und dort zu eventuell größeren Schäden führen. Gegebenenfalls löst zeitverzögert eine Vorsicherung (z.B. Leitungsschutzschalter) aus, wodurch unnötigerweise größere Anlagenbereiche spannungslos geschaltet werden. Im schlimmsten Fall kann durch den Überlast- oder Kurzschlussstrom die Leistungsfähigkeit der Stromversorgungseinheit überschritten werden, wodurch die gesamte Anlage ausfällt, da die speisende Stromversorgungseinheit durch den unerwarteten zusätzlichen Strombedarf überlastet wird.

Aus der Schrift WO 2010/018018 A1 ist ein Verfahren bekannt, bei welchem in einem Beobachtungszeitraum für einen Verbraucher bzw. eine Lasteinheit in einer technischen Anlage der für den laufenden Betrieb höchste, notwendige Auslösestromwert ermittelt wird, um diesen in einer einstellbare Sicherung anzupassen. Dazu wird der vom Verbraucher aufgenommene Strom während mehrere Beobachtungszeitintervalle von einer Steuereinheit gemessen. Für jedes Beobachtungszeitintervall wird ein Maximalwert des gemessenen Stroms bestimmt und gespeichert. Aus den gemessenen Maximalwerten, welche mit einer Sicherheitsreserve versehen werden, wird dann z.B. mittels langsamer Mittelwertbildung ausgehend von einem Default-Wert (z.B. Nennstrom, etc.) ein statischer Grenzwert zur Anpassung des Auslöseparameters bzw. -stroms bestimmt. Dabei kann neben dem statischen Grenzwert für den laufenden Betrieb auch ein dynamischer Grenzwert für Einschaltvorgänge des Verbrauchers ermittelt werden.

Allerdings ist eine Summe der eingestellten bzw. ermittelten Werte der Auslöseparameter, insbesondere des Auslösestroms, bei welchen die einzelnen Sicherungen bzw. Schaltereinheiten zu Absicherung der Lastkreise auslösen, nicht selten deutlich höher als eine Leistungsfähigkeit der speisenden Stromversorgungseinheit, insbesondere wenn beispielsweise beim Betrieb der Anlage mehrere Lasteinheiten (Magnetventile, Stellmotoren, Schützspulen, etc.) von zumeist mehreren Lastkreisen gleichzeitig eingeschaltet werden. Bei dem aus der Schrift WO 2010/018018 A1 bekannten Verfahren werden zwar die Auslöseparameter, insbesondere der Wert des Auslösestroms der einzelnen Sicherungen zur Absicherung der einzelnen Verbraucher an die Betriebsbedingungen der Anlage angepasst. Dabei werden allerdings die Leistungsfähigkeit der Stromversorgungseinheit bei Versorgung mehrerer angeschlossener Verbraucher bzw. Lastkreisen sowie eine Verteilung des Ausgangsstroms auf die einzelnen Verbraucher bzw. Lastkreise kaum berücksichtigt. Weiterhin kann es auch zu fehlerhaften Abschaltungen von Lastkreisen oder Lasteinheiten kommen, da nur die Stromaufnahme des einzelnen Lastkreise bzw. der angeschlossenen Lasteinheiten ausschlaggebend dafür ist, bei welchem aktuellen Stromwert die Schaltereinheit der Schutzeinrichtung auslöst. D.h. ein von einem Lastkreis aufgenommener Strom wird z.B. begrenzt oder abgeschaltet, obwohl die Stromversorgungseinheit noch ausreichend Leistungsfähigkeit für dessen Versorgung aufweist, oder weil auf Basis von historischen Maximalwerten im Beobachtungszeitraum ein zu niedriger Auslösewert ermittelt wurde. Dies führt beispielsweise zu unnötigen Abschaltungen von zumindest Teilen der Anlage.

### Darstellung der Erfindung

Der Erfindung liegt daher die Aufgabe zugrunde, ein gegenüber dem Stand der Technik weiterentwickeltes Verfahren anzugeben, welches im laufenden Betrieb einer technischen Anlage auf einfache Weise und mit geringem Aufwand für eine Projektierung der Anlage eine sichere und möglichst fehlerfreie Funktionsweise der Anlage, insbesondere von Lastkreisen einer Anlagensteuerung sowie einer die Lastkreise der Anlagensteuerung versorgenden Stromversorgungseinheit ermöglicht.

Diese Aufgabe wird durch ein Verfahren der eingangs genannten Art mit den Merkmalen gemäß dem unabhängigen Patentanspruch gelöst. Vorteilhafte Ausführungsformen der vorliegenden Erfindung sind in den abhängigen Ansprüchen beschrieben.

Erfindungsgemäß erfolgt die Lösung der Aufgabe durch ein Verfahren zum Überprüfen und Steuern einer Stromverteilung in Lastkreisen einer Anlagensteuerung einer technischen Anlage der eingangs genannten Art. Dabei wird während einer Lernphase zumindest in jenen Lastkreisen, welche durch eine Schaltereinheit abgesichert sind, ein Stromverlauf des von einem jeweiligen Lastkreis aufgenommenen Stroms gemessen. Dann wird aus dem für den jeweiligen Lastkreis gemessenen Stromverlauf zumindest ein signifikantes Stromprofil sowie ein zum Stromprofil zugehöriger Toleranzbereich abgeleitet und dem jeweiligen Lastkreis zugeordnet. Während des laufenden Betriebs der Anlage wird von der Steuereinheit laufend ein Stromverlauf überwacht, welcher zumindest für jene Lastkreise gemessen wird, die mit einer Schaltereinheit abgesichert sind. Weiterhin wird von der Steuereinheit geprüft, ob von der getakteten Stromversorgungseinheit eine Leistungsfähigkeitsgrenze zumindest erreicht oder überschritten wird. Bei zumindest Erreichen oder Überschreiten der Leistungsfähigkeitsgrenze durch die getaktete Stromversorgungseinheit wird von der Steuereinheit durch Ansteuern der Schaltereinheit in jenen Lastkreisen der vom jeweiligen Lastkreis aufgenommene Strom zumindest reduziert und/oder abgeschaltet, bei welchen vom aktuell für den jeweiligen Lastkreis gemessenen Stromverlauf eine obere Grenze des Toleranzbereichs des dem jeweiligen Lastkreis zugeordneten, signifikanten Stromprofils überschritten wird.

Der Hauptaspekt der erfindungsgemäß vorgeschlagenen Lösung besteht darin, dass für die Lastkreise der Anlagensteuerung so viel Strom bzw. Energie geliefert wird, wie vom jeweiligen Lastkreis bzw. von der zum jeweiligen Lastkreis gehörenden, zumindest einen Lasteinheit zu einem aktuellen Zeitpunkt im laufenden Betrieb benötigt wird, solange die getaktete Stromversorgungeinheit nicht ihre Leistungsfähigkeitsgrenze erreicht bzw. überschreitet. Bei Erreichen oder Überschreiten dieser Leistungsfähigkeitsgrenze wird dann über entsprechende Ansteuerung der Schaltereinheiten in jenen Lastkreisen der Strom reduziert und/oder abgeschaltet, welche über ein normales bzw. übliches Maß hinaus Strom aufnehmen bzw. welche ein "auffälliges" Stromverhalten zeigen. Das normale bzw. übliche Maß an Strombedarf eines jeweiligen Lastkreises wird anhand des in der Lernphase für den jeweiligen Lastkreis ermittelten Stromprofils mit zugehörigem Toleranzbereich bestimmt. Es ist daher nicht mehr notwendig, für die mit einer Schaltereinheit abgesicherten Lastkreise der Anlage passende Auslösewerte für die absichernden Schaltereinheiten zu bestimmen, bei welchen im jeweilige Lastkreis der Strom reduziert und/oder abgeschaltet wird. Es wird stattdessen als begrenzender Faktor die Leistungsfähigkeit der versorgenden Stromversorgungseinheit herangezogen. Dadurch werden idealerweise Fehleinstellungen bei der Anlagenplanung oder -installation, insbesondere zu hoch eingestellte Auslösewerte von als elektronische Sicherungen fungierenden Schaltereinheiten verhindert. Weiterhin werden das statische wie dynamische Stromverhalten der Lastkreise in Kombination sowie eine Verteilung eines Ausgangsstroms der Stromversorgungseinheit auf die einzelnen Lastkreise und deren Lasteinheiten berücksichtigt.

Es ist günstig, wenn zum Erkennen eines Erreichens der Leistungsfähigkeitsgrenze der getakteten Stromversorgungseinheit von der Steuereinheit die Ausgangsspannung der getakteten Stromversorgungseinheit oder eine Summe aktueller Strommesswerte der von den Lastkreisen jeweils aufgenommenen Ströme überwacht wird. Im einfachsten Fall wird die Ausgangsspannung der getakteten Stromversorgungseinheit - d.h. die Versorgungsspannung - als Kriterium von der Steuereinheit herangezogen. Dabei wird überwacht, ob die Ausgangsspannung der getakteten Stromversorgungseinheit einen vorgegebenen Grenzwert (z.B. 20 V) erreicht oder unterschreitet. Optional können - bei bekannter Charakteristik der Stromversorgungseinheit - auch mehrere Spannungsgrenzwerte vorgegeben werden, welche einer jeweils aktuellen Information zum Überlastzustand der Stromversorgungseinheit entsprechen. Die Spannungsgrenzwerte können gestaffelt ausgewertet bzw. mit der aktuellen Ausgangsspannung der Stromversorgungseinheit verglichen werden und daraus ein aktueller Grad der jeweiligen Überlastung und entsprechende Maßnahmen (z.B. Reduktion und/oder Abschaltung des Stroms in einzelnen Lastkreisen, in mehreren Lastkreisen, etc.) abgeleitet werden.

Alternativ kann die Steuereinheit auch einen aktuellen Summenwert aus aktuellen Stromwerten des von den Lastkreisen aufgenommenen Stroms errechnen und diesen Summenwert als Kriterium verwenden. Dabei wird von der Steuereinheit geprüft, ob der jeweilige Summenwert einen vorgegebenen Grenzwert erreicht und/oder übersteigt. Die vorgegebenen Grenzwerte für die Ausgangsspannung bzw. für den aktuellen Summenwert der aktuell in die Lastkreisen aufgenommenen Ströme ergeben sich idealerweise aus einer Überlastfähigkeit der Stromversorgungseinheit.

Es kann idealerweise eine Zeitspanne vorgegeben werden, während welcher die Leistungsfähigkeitsgrenze der getakteten Stromversorgungeinheit um eine vorgegebene Höhe überschritten werden darf. D.h. die Stromversorgungseinheit kann für eine kurzfristige, vorgebbare Zeitdauer (z.B. 5 ms) einen vorgebbaren Überstrom als Ausgangsstrom zur Verfügung stellen, welcher über einen normalerweise gelieferten Dauerstrom hinausgeht. Diese Überlastfähigkeit kann zum Abdecken von dynamischen Stromverhaltensvorgängen in der Anlage (z.B. paralleles Anschalten mehrerer Lastkreise, etc.) genutzt werden.

Eine zweckmäßige Weiterbildung sieht vor, dass zum Erkennen des Erreichens der Leistungsfähigkeitsgrenze der getakteten Stromversorgungseinheit von der getakteten Stromversorgungseinheit laufend aktuelle Auslastungswerte oder ein Erreichen und/oder Überschreiten der Leistungsgrenze an die Steuereinheit übertragen werden. Die Stromversorgungseinheit kann beispielsweise eine interne thermische Situation (z.B. Temperatur, Erwärmungsgrad, etc.), Eingangsspannungsschwankungen (z.B. Spannungsspitzen, Netzstörungen, Phasenausfall, etc.), etc. erfassen und daraus z.B. von einer aktuellen Situation abhängige Parameter berechnen, welche die aktuelle Leistungsfähigkeit der getakteten Stromversorgungseinheit wiedergeben. Diese Parameter werden als aktuelle Auslastungswerte an die Steuereinheit weitergeleitet und können von dieser zur Überwachung der Leistungsfähigkeitsgrenze der Stromversorgungseinheit herangezogen werden. Dadurch wird in vorteilhafter Weise eine aktuelle Situation der Stromversorgungseinheit, wie z.B. Erwärmung, Störungen in der Eingangsspannung, etc. mitberücksichtigt. Weiterhin kann anhand der aktuellen Auslastungswerte vorausberechnet werden, wann von der Stromversorgungseinheit z.B. zwecks Eigenschutz die Ausgangsspannung abgeregelt werden muss bzw. die Leistungsfähigkeitsgrenze zumindest erreicht wird.

Idealerweise wird der Steuereinheit eine Reihenfolge für eine Reduktion und/oder eine Abschaltung des Stroms in jenen Lastkreisen vorgegeben, in welchen die obere Grenze des Toleranzbereichs des dem jeweiligen Lastkreis zugeordneten, signifikanten Stromprofils überschritten wird. Dabei kann z.B. festgelegt werden, dass zuerst der aufgenommene Strom in jenen Lastkreisen reduziert und/oder abgeschaltet werden, von welchen beispielsweise die Stromversorgungseinheit am stärksten belastet wird bzw. welche am meisten Strom aufnehmen. Damit kann auf einfache und rasche Weise für eine Entlastung der Stromversorgungseinheit gesorgt werden.

Weiterhin wird in vorteilhafter Weise jenen Lastkreisen von der Steuereinheit eine Statusmarkierung zugeordnet, bei welchen vom aktuell für den jeweiligen Lastkreis gemessenen Stromverlauf im laufenden Betrieb der Anlage die obere Grenze des Toleranzbereichs des dem jeweiligen Lastkreis zugeordneten, signifikanten Stromprofils überschritten wird. Dadurch werden auf einfache Weise toleranzüberschreitende Lastkreise gekennzeichnet, welche während des laufenden Betriebs der Anlage einen über das übliche Maß hinausgehend Strom aufnehmen. Sinkt beispielsweise ein Strombedarf eines Lastkreises - d.h. der aktuell gemessene Stromverlauf dieses Lastkreises verläuft wieder innerhalb des Toleranzbereichs des zum jeweiligen Lastkreis zugeordneten, signifikanten Stromprofils, kann vorgesehen sein, dass die Statusmarkierung dieses Lastkreises z.B. wieder zurückgesetzt werden.

Es ist daher günstig, wenn bei Erreichen und/oder Überschreiten der Leistungsfähigkeitsgrenze der getakteten Stromversorgungseinheit von der Steuereinheit die Statusmarkierung herangezogen wird, welche dem jeweiligen Lastkreis aktuell zugeordnet ist. Damit können auf einfache und rasche Weise bei Eintreten eines Versorgungsengpasses oder eines Versorgungsnotfalls jene Lastkreise identifiziert werden, in welchen eine Stromreduktion und/oder -abschaltung durchgeführt werden soll.

Weiterhin kann idealerweise anhand der während des laufenden Betriebs der Anlage von der Steuereinheit überwachten, aktuell gemessenen Stromverläufe der Lastkreise für jene Lastkreise eine Alarmmeldung ausgegeben werden, bei welchen vom aktuell für den jeweiligen Lastkreis gemessenen Stromverlauf im laufenden Betrieb der Anlage die obere Grenze des Toleranzbereichs des dem jeweiligen Lastkreis zugeordneten, signifikanten Stromprofils überschritten wird. Diese Alarmmeldung kann beispielsweise protokolliert oder an einen Bediener der Anlage weitergeleitet werden und liefert idealerweise Aufschluss über ein "auffälliges" Stromverhalten in einem Lastkreis der Anlage. Weiterhin können die Alarmmeldungen z.B. nach Systemgefährdung gewichtet werden. Dazu kann z.B. ausgewertet werden, ob in einem Lastkreis der Toleranzbereich des zugehörigen, signifikanten Stromprofils vom jeweils aufgenommenen Strom nur geringfügig und/oder kurzfristig überschritten wird oder ob eine größere und/oder länger andauernde Überschreitung des Toleranzbereichs des jeweiligen Stromprofils vorliegt.

Eine zweckmäßige Ausgestaltung der Erfindung sieht vor, dass für die Reduktion des vom jeweiligen Lastkreis aufgenommenen Stroms die Schaltereinheit des jeweiligen Lastkreises von der Steuereinheit derart angesteuert wird, dass der vom jeweiligen Lastkreis aufgenommene Strom zeitlich begrenzt wird. D.h., im Fall eines Versorgungengpasses oder Versorgungsnotfalls wird die den jeweiligen Lastkreis absichernde Schaltereinheit linear angesteuert, um den Strom im jeweiligen Lastkreis auf einem vorgegebenen Wert zu halten, unabhängig vom Verhalten der im Lastkreis angeordneten zumindest einen Lasteinheit bzw. einer Nennbelastung. Alternativ kann die Schaltereinheit des jeweiligen Lastkreises für die Reduktion des in den jeweiligen Lastkreis aufgenommenen Stroms von der Steuereinheit auch derart angesteuert wird, dass die Schaltereinheit in einen Taktbetrieb geschaltet werden. D.h. die Schaltereinheit wird in diesem Fall von der Steuereinheit gepulst angesteuert, um den Strom im jeweiligen Lastkreise auf einem vorgegebenen Wert zu halten. Im einfachsten Fall wird der vom jeweiligen Lastkreis aufgenommene Strom z.B. nach einer vorgegebenen Zeit komplett abgeschaltet, wobei die den Lastkreis absichernde Schaltereinheit entsprechend angesteuert wird.

Es ist weiterhin günstig, wenn das signifikante Stromprofil des jeweiligen Lastkreises in der Lernphase anhand von Vorgabedaten aus dem für den jeweiligen Lastkreis gemessenen Stromverlauf abgeleitet wird. Diese Vorgabedaten umfassen idealerweise typische und charakteristische Strommuster von in Lastkreisen häufig verwendeten Lasteinheiten. Derartige Strommuster sind z.B. für einzelne Lasteinheiten charakteristische Verlaufsformen des Stroms. Die Vorgabedaten können dabei folgende, beispielhafte Strommuster umfassen: ein rein ohmsches Profil, welche z.B. typisch für einfache Sensoren, Heizungselemente, etc. ist; ein kapazitiv-strombegrenztes Profil mit einer Stromspitze, welche nach einer dem Verlauf einer Exponentialfunktion abklingt, und welches typisch für z.B. für Sensoreinheiten sein kann; ein induktiv-ohmsches Profil z.B. mit einer Delle, welches typisch für z.B. Magnetventile, Schütz, etc. ist; ein Profil mit einem Stromanstieg, gefolgt von einer Wartezeit und einem erneuten Stromanstieg, welches z.B. typischerweise Steuerungen beim Hochfahren aufweisen; etc. Die charakteristischen Strommuster werden beispielsweise anhand historischer Stromverläufe z.B. auf einer eigenen Rechnereinheit (z.B. PC) ermittelt und der Steuereinheit als Vorgabedaten z.B. vor der Lernphase, idealerweise vor einer Erstinbetriebnahme der Anlage, vorgegeben, um die signifikanten Stromprofile der Lastkreise der Anlagensteuerung rascher abzuleiten.

Idealerweise wird für eine Ableitung des signifikanten Stromprofils des jeweiligen Lastkreises ein trainiertes, neuronales Netz verwendet. Durch die Verwendung eines trainierten, neuronalen Netzes kann die Ableitung des jeweiligen signifikanten Stromprofils der Lastkreise der Anlage erheblich beschleunigt werden. Ein Training des neuronalen Netzes kann beispielsweise auf einer eigenen Rechnereinheit, z.B. einem PC, unter Verwendung von Trainingsdaten, wie z.B. typische und charakteristische Strommuster von in Lastkreisen häufig verwendeten Lasteinheiten, etc. erfolgen. Durch das Training erhält das neuronale Netz eine Ansammlung an gewichteten Entscheidungskriterien, die es ihm erlauben rasch zwischen unterschiedlichen Strommuster zu unterscheiden und rasch wiederkehrende Strommuster in gemessenen Stromverläufen von Lastkreisen zu erkennen. Das trainierte, neuronale Netz wird z.B. nach entsprechendem Training und vor der Lernphase, idealerweise vor der Erstinbetriebnahme der Anlage, auf die Steuereinheit übertragen und kann dort in der Lernphase das Auffinden der für die jeweiligen Lastkreise signifikanten Stromprofile und das Bestimmen der jeweils zugehörigen Toleranzbereiche - d.h. in Stromhöhe, Dauer und Verlaufsform in den jeweiligen Stromverläufen wiederkehrende Strommuster inklusive jeweiliger Schwankungsbereiche - erheblich beschleunigen.

Eine bevorzugte Fortbildung der Erfindung sieht vor, dass für die Lernphase, in welcher aus einem für einen jeweiligen Lastkreis gemessenen Stromverlauf ein für den jeweiligen Lastkreis signifikantes Stromprofil abgeleitet wird, eine Mindestdauer vorgegeben wird. Die Mindestdauer der Lernphase stellt zumindest sicher, dass für jeden der Lastkreis zumindest zwei typische, wiederkehrende Strommuster im für den jeweiligen Lastkreis gemessenen Stromverlauf gefunden wurden, sodass anhand der zumindest zwei typischen, wiederkehrenden Strommuster ein signifikantes Stromprofil sowie ein zumindest grober Toleranzbereich für dieses Stromprofil festgelegt werden kann.

Im Maximalfall kann die Lernphase die gesamte Lebensdauer der Anlage umfassen. D.h. es werden auch während des laufenden Betriebs die für die Lastkreise gemessenen Stromverläufe auf typische Strommuster überprüft, um das zugeordnete, signifikante Stromprofil sowie den zugehörigen Toleranzbereich des jeweiligen Lastkreises laufend zu verfeinern und zu verbessern. Weiterhin kann eine Veränderung eines signifikanten Stromprofils (z.B. in Höhe, Dauer und/oder Verlaufsform) einen Indikator für eine Alterung oder eine drohende Fehlfunktion einer Lasteinheit im zugehörigen Lastkreis darstellen. Von der Steuereinheit können derartige Veränderungen sehr leicht erkannt werden.

So kann z.B. der für einen betroffenen Lastkreis während des Anlagenbetriebs gemessene Stromverlauf dauerhaft den Toleranzbereich des dem Lastkreis zugeordneten, signifikanten Stromprofils über- oder unterschreiten. Der betroffene Lastkreis kann beispielsweise dem Bediener der Anlage z.B. mittels einer Alarmmeldung gemeldet werden. Vor der Alarmmeldung kann z.B. noch eine Relevanzprüfung durchgeführt werden, wobei die Abweichungen vom signifikanten Stromprofil bzw. das Über- oder Unterschreiten des zugehörigen Toleranzbereichs nur bei einer vorgegebenen Mindestabweichung von z.B. der Stromhöhe und/oder der Verlaufsform des signifikanten Stromprofils gemeldet wird.

Weiterhin können wiederholte Abweichungen vom signifikanten Stromprofil bzw. wiederholte Über- oder Unterschreitungen des zugehörigen Toleranzbereichs zu einer entsprechenden Anpassung des signifikanten Stromprofils eines Lastkreises oder des zugehörigen Toleranzbereichs führen, sofern vorgegebene Kriterien erfüllt sind. Ein mögliches Kriterium ist beispielsweise, dass die Abweichungen vom Stromprofil bzw. wiederholte Über- oder Unterschreitungen des zugehörigen Toleranzbereichs regelmäßig oder gleichmäßig auftreten. Dadurch kann z.B. angenommen werden, dass diese einem "normalen" Stromverlauf im betroffenen Lastkreis entsprechen. Die Anpassung des signifikanten Stromprofils des betroffenen Lastkreises bzw. des zugehörigen Toleranzbereichs kann z.B. automatisch erfolgen. Es kann aber auch vorgesehen sein, dass ein Bediener der Anlage eine derartige Anpassung bestätigen muss. Der Bediener kann sich beispielsweise davor vergewissern, dass keine offensichtlichen Defekte oder ein ungewöhnliches Betriebsverhalten im betroffenen Lastkreis aufgetreten ist.

Da zumindest eine Mehrzahl der Lastkreise der Anlagensteuerung von einer Schaltereinheit abgesichert wird, welche als elektronische Sicherungen fungiert, wird für jeden mit einer Schaltereinheit abgesicherten Lastkreis idealerweise ein Sicherheitsgrenzwert vorgegeben, bei dessen Erreichen und/oder Überschreiten der vom jeweiligen Lastkreis aufgenommene Strom immer abgeschaltet wird. Bei diesem Sicherheitsgrenzwert, welcher idealerweise oberhalb der oberen Grenze des Toleranzbereichs des dem jeweiligen Lastkreis zugeordneten, signifikanten Stromprofils gelegen sein sollte, handelt es sich um einen maximalen Wert für den Lastkreis-Strom. Der Sicherheitsgrenzwert wird eingestellt, um Brandschutzbedingungen zu erfüllen und im schlimmsten Fall bei einer defekten Lasteinheit im einem Lastkreis im schlimmsten Fall einen Brand zu verhindern.

Weiterhin ist es vorteilhaft, wenn z.B. zur Erfüllung von Brandschutzbedingungen eine zusätzliche Schutzeinrichtung vorgesehen wird. Der Schaltereinheit, welche den jeweiligen Lastkreis absichert, ist dabei z.B. die weitere Schutzeinrichtung (z.B. Leitungsschutzschalter, Schmelzsicherung, etc.) vorgeschaltet, welche beispielsweise bei Versagen der Schaltereinheit in jedem Fall ausgelöst wird. Die Schutzeinrichtung kann dazu z.B. derart gewählt werden, dass nur Stromhöhen oder -verläufe durchgelassen werden, bei welchen die Leitung und die zumindest eine Lasteinheit im Lastkreis vor Schaden und/oder Brand geschützt sind.

Eine günstige Ausführung der Erfindung sieht vor, dass als Schaltereinheit ein Leistungstransistor oder ein Mikro-Elektronisch-Mechanisches-System, kurz MEMS, eingesetzt wird. Leistungstransistoren sowie ein MEMS stellen einen elektronischen Schalter dar, welche sehr einfach von einer Steuereinheit angesteuert werden können, um einen Strom zu begrenzen. Weiterhin kann durch entsprechende Ansteuerung der Strom von einem Leistungstransistor oder einem MEMS als Schaltereinheit sehr einfach unterbrochen werden. MEMS sind üblicherweise winzige Halbleiterbauelemente, welche idealerweise Logikelemente und mikromechanische Strukturen (z.B. Anker, welche über elektrostatische Kräfte bewegt werden) in einem Bauelement vereinen.

### Kurzbeschreibung der Zeichnung

Die Erfindung wird nachfolgend in beispielhafter Weise anhand der beigefügten Figuren erläutert. Es zeigen:
Figur 1 eine schematische und beispielhafte Anordnung zur Durchführung des erfindungsgemäßen Verfahren zum Überwachen und Steuern einer Stromverteilung in Lastkreisen in einer technischen Anlage;
Figur 2 einen beispielhaften Ablauf des erfindungsgemäßen Verfahren zum Überwachen und Steuern einer Stromverteilung in Lastkreisen in einer technischen Anlage.

### Ausführung der Erfindung

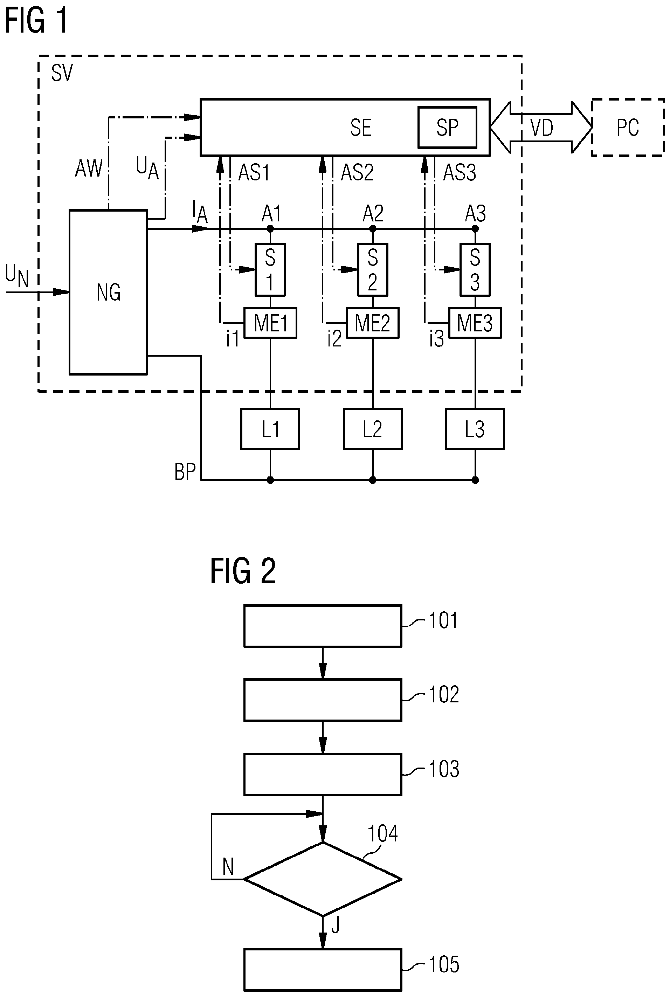

Figur 1 zeigt in schematischer Weise eine beispielhafte Anordnung SV für eine Stromversorgung einer Anlagensteuerung in einer technischen Anlage. Mit der beispielhaften Anordnung SV kann eine Stromverteilung in Lastkreisen L1, L2, L3 der Anlagensteuerung überwacht und gesteuert werden. Dazu weist die Anordnung SV eine getaktete Stromversorgungseinheit NG, wie z.B. ein Schaltnetzteil auf, welche von einer Netzspannung U_{N} - beispielsweise einer Gleichspannung, einer ein- oder dreiphasigen Wechselspannung - gespeist wird. Die getaktete Stromversorgungseinheit NG ist an ein Bezugspotential BP (z.B. 0 Volt) angebunden und liefert eine Ausgangsspannung U_{A} mit einem geregelten und zumeist vorgegebenen Wert (z.B. 24 Volt) sowie einen Ausgangsstrom I_{A}. Weiterhin können von der Stromversorgungseinheit NG, sofern diese dazu eingerichtet ist, laufend aktuelle Auslastungswerte AW an eine Steuereinheit SE übertragen werden.

Weiterhin ist für die Anlagensteuerung zumindest ein Lastkreis L1, L2, L3 vorgesehen. Meist weist eine Anlagensteuerung jedoch mehrere Lastkreise L1, L2, L3 auf. Die einzelnen Lastkreise L1, L2, L3 weisen zumindest eine Lasteinheit, wie z.B. Sensor, Aktor, Relais, Schütz, Magnetventil, Antriebseinheit für einen Motor, Stellmotor, Steuerung, Anzeigeeinheit, etc., auf. Die Lastkreise L1, L2, L3 sind einerseits ebenfalls mit dem Bezugspotential verbunden. Andererseits sind die Lastkreise L1, L2, L3 für eine Energieversorgung der Lasteinheiten über Abzweige A1, A2, A3 mit der getakteten Stromversorgungseinheit NG verbunden. Die von der Stromversorgungseinheit NG zur Verfügung gestellte Ausgangsspannung U_{A} bzw. der Ausgangsstrom I_{A} werden dazu auf die jeweiligen Lastkreise L1, L2, L3 aufgeteilt.

Weiterhin ist zumindest eine Mehrzahl der Lastkreise L1, L2. L3 durch eine Schaltereinheit S1, S2, S3, abgesichert. D.h. es können z.B. einzelne Lastkreise L1, L2, L3, welche einen sehr geringen Strom benötigen und/oder fast immer versorgt werden müssen (z.B. ein Lastkreis L1, L2, L3 mit einer Steuerung als Lasteinheit) kein Schaltereinheit S1, S2, S3 zur Absicherung aufweisen. Idealerweise sind alle Lastkreise L1, L2, L3 mit einer Schaltereinheit S1, S2, S3 abgesichert - wie in Figur 1 beispielhaft dargestellt. Die Schaltereinheit S1, S2, S3 fungiert dabei als elektronische und einstellbare Sicherung für den jeweiligen Lastkreis L1, L2, L3. Jede Schaltereinheit S1, S2, S3 wird dazu mittels entsprechender Steuersignale AS1, AS2, AS3 einer Steuereinheit SE angesteuert. Dadurch kann ein vom jeweiligen Lastkreis L1, L2, L3 aufgenommener Strom und damit eine Verteilung des Ausgangsstroms I_{A} der Stromversorgungseinheit NG auf die Lastkreise L1, L2, L3 entsprechend gesteuert werden. Als Schaltereinheit S1, S2, S3 kann beispielsweise ein Leistungstransistor oder ein Mikro-Elektronisch-Mechanisches-System, kurz MEMS, verwendet werden. Zusätzlich kann eine weitere Schutzeinrichtung (z.B. Leitungsschutzschalter, Schmelzsicherung, etc.) vorgesehen sein, welche z.B. der jeweiligen Schaltereinheit S1, S2, S3 vorgeschaltet ist. Die zusätzlichen Schutzeinrichtungen sind in Figur 1 der Einfachheit halber nicht dargestellt.

Weiterhin ist in einem Abzweig A1, A2, A3 des jeweiligen Lastkreises L1, L2, L3 eine Messeinheit ME1, ME2, ME3 vorgesehen. Von der Messeinheit ME1, ME2, ME3 wird ein aktueller Stromverlauf i1, i2, i3 des vom jeweiligen Lastkreis L1, L2, L3 aufgenommenen Stroms gemessen und an die Steuereinheit SE für eine entsprechende Überwachung und Auswertung weitergeleitet.

Als Steuereinheit SE, von welcher mittels Steuersignalen AS1, AS2, AS3 die Schaltereinheiten S1, S2, S3 angesteuert werden und welche die Stromverläufe i1, i2, i3 in den Lastkreisen L1, L2, L3 überwacht, kann beispielsweise ein Mikroprozessor eingesetzt werden.

Weiterhin kann die Steuereinheit SE zumindest eine Speichereinheit SP aufweisen, in welcher z.B. zu überwachende Grenzwerte für die Ausgangsspannung U_{A} der Stromversorgungseinheit, Grenzwerte für eine Summe der Ströme in den Lastkreisen L1, L2, L3 und/oder einstellbare Werte für die Schaltereinheiten S1, S2, S3 abgelegt sind. In der Speichereinheit SP der Steuereinheit SE können weiterhin z.B. für jede Schaltereinheit SE ein vorgebbarer Sicherheitsgrenzwert hinterlegt sein. Bei diesem vorgebbaren Sicherheitsgrenzwert (z.B. maximal zulässiger Lastkreis-Strom) wird von der jeweiligen Schaltereinheit S1, S2, S3 der vom jeweiligen Lastkreis L1, L2, L3 aufgenommene Strom auf jeden Fall unterbrochen. Weiterhin können in der Speichereinheit SP Vorgabedaten VD (z.B. Strommuster, Entscheidungskriterien für ein neuronales Netz, etc.) abgelegt werden, welche beispielsweise auf einer externen Rechnereinheit PC ermittelt werden und bei der Durchführung des Verfahrens zum Überwachen und Steuern der Stromverteilung in den Lastkreisen L1, L2, L3 benötigt werden.

Um die Lasteinheiten der Anlagensteuerung in Lastkreise L1, L2, L3 einzuteilen, kann beispielsweise die getaktete Stromversorgungseinheit NG selbst z.B. zumindest einen oder mehrere Ausgänge A1, A2, A3 aufweisen, an welche die Lastkreise L1, L2, L3 direkt angeschlossen werden. Dabei ist dann jeder Ausgang A1, A2, A3 mit einer Schaltereinheit S1, S2, S3 abgesichert und eine Messeinheit ME1, ME2, ME3 zum Messen des Stromverlaufs i1, i2, i3 in einem angeschlossenen Lastkreis L1, L2, L3 aufweisen. Weiterhin ist dann die Steuereinheit SE in die Stromversorgungseinheit NG integriert. D.h., die Stromversorgungseinheit umfasst die in Figur 1 von der strichlierten Linie umfassten Einheiten und entspricht damit der in Figur 1 beispielhaft dargestellten Anordnung SV.

Alternativ kann der getakteten Stromversorgungseinheit NG zumindest eines oder mehrere elektronische Sicherungsmodule, wie z.B. die Selektivitätsmodule SITOP SEL1200 oder SITOP SEL1400 der Firma Siemens, nachgeschaltet sein. Dann weist das jeweilige Sicherungsmodule die Ausgänge A1, A2, A3 auf, an welche die Lastkreise L1, L2, L3 angebunden sind. Dabei umfasst das Sicherungsmodul die Schaltereinheiten S1, S2, S3 zum Absichern der Ausgänge A1, A2, A3 bzw. der angebundenen Lastkreise L1, L2, L3, die Messeinheiten ME1, ME2, ME3 zum Messen des Stromverlaufs i1, i2, i3 in den angeschlossenen Lastkreisen L1, L2, L3 sowie die Steuereinheit SE.

Bei Einsatz mehrerer Sicherungsmodule kann die Steuereinheit SE beispielsweise in mehrere Funktionseinheiten unterteilt sein, welche auf die jeweiligen Sicherungsmodule verteilt sind. Die Sicherungsmodule bzw. die darauf angeordnete zumindest eine Funktionseinheit der Steuereinheit SE sind z.B. über einen Datenbus verbunden, wobei ein der verteilten Funktionseinheiten eine so genannte Master-Funktionseinheit für eine übergeordnete Steuerung bzw. Überwachung der Lastkreise L1, L2, L3 ist und die weiteren verteilten Funktionseinheiten als so genannte Slave-Funktionseinheiten für eine lokal und rasche Steuerung bzw. Überwachung der an das jeweilige Sicherungsmodul angeschlossenen Lastkreise L1, L2, L3 fungieren. Für die Funktionseinheiten der Steuereinheit SE kann weiterhin in jedem Sicherungsmodul eine Speichereinheit SP vorgesehen sein, in welcher zumindest jene Werte (z.B. Sicherungsgrenzwerte, etc.) abgelegt sind, welche lokal eine Steuerung und Überwachung des Stroms in den jeweils an das jeweilige Sicherungsmodul angeschlossenen Lastkreisen L1, L2, L3 notwendig sind.

Die Figur 2 zeigt beispielhaft einen Ablauf des erfindungsgemäßen Verfahrens zum Überwachen und Steuern der Stromverteilung in den Lastkreisen L1, L2, L3 einer Anlagensteuerung in einer technischen Anlage, wie beispielhaft in Figur 1 dargestellt.

In einer Lernphase, welche z.B. mit einer Erstinbetriebnahme der Anlage gestartet werden kann, wird in einem Messschritt 101 zumindest in jedem mit einer Schaltereinheit S1, S2, S3 abgesicherten Lastkreis L1, L2, L3 der Stromverlauf i1, i2, i3 des vom jeweiligen Lastkreis L1, L2, L3 aufgenommenen Stroms gemessen. Die Messung kann beispielsweise mittels der für den jeweiligen Lastkreis vorgesehenen Messeinheit ME1, ME2, ME3 durchgeführt werden. Ein für den jeweiligen Lastkreis L1, L2, L3 gemessener Stromverlauf i1, i2, i3 wird dann an die Steuereinheit SE weitergeleitet.

In einem Ableitungsschritt 102, welcher ebenfalls zur Lernphase gehört, wird aus dem für den jeweiligen Lastkreis L1, L2, L3 gemessenen Stromverlauf i1, i2, i3 ein signifikantes Stromprofil mit einem zugehöriger Toleranzbereich abgeleitet. Dazu wird der für den jeweiligen Lastkreis L1, L2, L3 gemessene Stromverlauf i1, i2, i3 nach einem wiederkehrenden, charakteristischen Strommuster durchsucht. Ein derartiges Strommuster stellt einen Abschnitt des jeweils gemessenen Stromverlaufs i1, i2, i3 dar, welcher annähernd eine selbe Stromhöhe, Dauer und/oder Verlaufsform aufweisen. Im Besonderen sollen die Strommuster die höchsten Strommomentanwerte beinhalten.

Aus dem für den jeweiligen Lastkreis L1, L2, L3 gefundenen, wiederkehrenden Strommuster wird dann das für diesen Lastkreis L1, L2, L3 signifikante Stromprofil abgeleitet, welches idealerweise ein statisches Stromverhalten und ein dynamisches Stromverhalten (z.B. Einschaltverhalten) des jeweiligen Lastkreise L1, L2, L3 während des laufenden Betriebs der Anlage bzw. der Anlagensteuerung repräsentiert. Weiterhin wird aus dem für den jeweiligen Lastkreis L1, L2, L3 gefundenen, wiederkehrenden Strommuster im Ableitschritt 102 ein zum signifikanten Stromprofil zugehöriger Toleranzbereich bestimmt. Der zugehörige Toleranzbereich ergibt sich aus einer Drift von z.B. Stromhöhe, Dauer und/oder Verlaufsform des im jeweiligen Stromverlauf i1, i2, i3 gefundenen, wiederkehrenden Strommusters für den jeweiligen Lastkreis L1, L2, L3. Der jeweilige Toleranzbereich kann gegebenenfalls mit einer Sicherheitsreserve beaufschlagt werden.

Zum Auffinden der charakteristischer Strommuster in den jeweiligen Stromverläufen i1, i2, i3 können im Ableitungsschritt 102 Vorgabedaten VD, wie z.B. häufig in Lastkreisen auftretender Strommuster und/oder Strommuster, welche typisch für häufig verwendete Lasteinheiten sind, eingesetzt werden. Die Vorgabedaten VD werden idealerweise vorab z.B. anhand historischer Stromverläufe von Lastkreisen L1, L2, L3 und/oder einzelner Lasteinheiten auf der externen Rechnereinheit PC ermittelt und z.B. vor der Lernphase auf die Steuereinheit SE übertragen und dort in der Speichereinheit SP gespeichert.

Um das Auffinden von Strommustern in den jeweiligen Stromverläufen i1, i2, i3 bzw. für eine Ableitung des signifikante Stromprofils des jeweiligen Lastkreises L1, L2, L3 und des jeweils zugehörigen Toleranzbereichs aus dem für den jeweiligen Lastkreis L1, L2, L3 gemessenen Stromverlauf i1, i2, i3 zu beschleunigen, kann im Ableitungsschritt 102 ein trainiertes, neuronales Netz eingesetzt werden. Das neuronale Netz wurde vor der Lernphase mit Trainingsdaten, wie z.B. typische und charakteristische Strommuster von in Lastkreisen L1, L2, L3 häufig verwendeten Lasteinheiten, etc. auf der externen Rechnereinheit PC trainiert und dann auf die Steuereinheit SE übertragen.

Für die Lernphase, welche zumindest den Messschritt 101 und den Ableitungsschritt 102 umfasst, kann beispielsweise eine Mindestdauer vorgesehen werden. In dieser Mindestdauer sollten in jedem gemessenen Stromverlauf i1, i2, i3 zumindest zwei charakteristische Strommuster für den jeweiligen Lastkreis L1, L2, L3 gefunden werden, um für den jeweiligen Lastkreis L1, L2, L3 zumindest ein signifikantes Stromprofil mit einem groben Toleranzbereich ableiten zu können. Nach der vorgegebenen Mindestdauer der Lernphase kann z.B. in einen laufenden Betrieb der Anlage übergegangen werden. Im Maximalfall kann die Lernphase allerdings die gesamte Lebensdauer der Anlage andauern. Dabei können die signifikanten Stromprofile der Lastkreise L1, L2, L3 und die zugehörigen Toleranzbereich auch während des laufenden Betriebs angepasst und verbessert werden. Dabei können z.B. geringe Über- und/oder Unterschreitungen des Toleranzbereichs eines Stromprofils zu einer Anpassung des jeweiligen, signifikanten Stromprofils führen. Größere oder massive Über- und/oder Unterschreitungen des Toleranzbereichs, welche z.B. anhand von vorgegebenen, prozentuellen Werten für die Über- und/oder Unterschreitung festgestellt werden, können beispielsweise als Fehler im jeweiligen Lastkreis L1, L2, L3 gewertet werden und z.B. einen Alarm oder eine Meldung an den Bediener der Anlage zur Folge haben.

Während des laufenden Betriebs der Anlage wird dann in einem Überwachungsschritt 103 von der Steuereinheit SE laufend der von der jeweiligen Messeinheit ME1, ME2, ME3 aktuell gemessene Stromverlauf i1, i2, i3 jedes Lastkreises L1, L2, L3 überwacht. Dabei kann von der Steuereinheit SE z.B. überprüft werden, ob vom aktuell für den jeweiligen Lastkreis L1, L2, L3 gemessenen Stromverlauf i1, i2, i3 eine obere Grenze des Toleranzbereichs des dem jeweiligen Lastkreis L1, L2, L3 zugeordneten, signifikanten Stromprofils überschritten wird. Wird eine derartiges Überschreiten festgestellt, so kann dem jeweilige Lastkreis L1, L2, L3 beispielsweise eine Statusmarkierung zugeordnet werden, welche z.B. so lange aufrecht bleibt, bis von der Steuereinheit SE festgestellt wird, dass der aktuell für den jeweiligen Lastkreis L1, L2, L3 gemessenen Stromverlauf i1, i2, i3 sich wieder innerhalb des Toleranzbereichs des dem jeweiligen Lastkreis L1, L2, L3 zugeordneten, signifikanten Stromprofils befindet. Alternativ oder zusätzlich kann auch von der Steuereinheit SE für jeden Lastkreis L1, L2, L3 eine Alarmmeldung ausgegeben werden, bei welchem vom aktuell für den jeweiligen Lastkreis L1, L2, L3 gemessenen Stromverlauf i1, i2, i3 die obere Grenze des Toleranzbereichs des dem jeweiligen Lastkreis L1, L2, L3 zugeordneten, signifikanten Stromprofils überschritten wird.

Weiterhin wird in einem Prüfschritt 104, welcher mehr oder weniger parallel zum Überwachungsschritt 103 abläuft, von der Steuereinheit SE geprüft, ob die getaktete Stromversorgungseinheit NG ihre Leistungsfähigkeitsgrenze bereits erreicht oder schon überschritten hat oder nicht. Um ein Erreichen und gegebenenfalls ein Überschreiten der Leistungsfähigkeitsgrenze durch die Stromversorgungseinheit NG im Prüfschritt 104 zu erkennen, kann die Steuereinheit beispielsweise die Ausgangsspannung U_{A} der Stromversorgungseinheit NG überwachen. Wird von der Ausgangsspannung U_{A} der Stromversorgungseinheit NG ein vorgegebener Grenzwert unterschritten, so hat die Stromversorgungseinheit NG ihr Leistungsfähigkeitsgrenze zumindest erreicht. D.h. die Stromversorgungseinheit NG kann bei einer aktuellen Strombelastung durch die Lastkreise L1, L2, L3 ihre vorgegebene Ausgangsspannung U_{A} nicht mehr halten und von der Steuereinheit SE wird begonnen, in einem Steuerschritt 105 in Lastkreisen L1, L2, L3 den aufgenommenen Strom zumindest zu reduzieren und/oder abzuschalten.

Alternativ zur Ausgangsspannung U_{A} der Stromversorgungseinheit NG kann von der Steuereinheit SE eine Summe aktueller Strommesswerte der von den Lastkreisen L1, L2, L3 aufgenommenen Ströme überwachen. Dazu werden von der Steuereinheit SE beispielsweise die aktuell mit den Messeinheiten ME1, ME2, ME3 gemessenen Stromverläufe i1, i2, i3 der Lastkreise L1, L2, L3 ausgewertet und daraus ein aktueller Summenwert der entsprechenden Strommesswerte bestimmt. Dieser Summenwert wird dann mit einem vorgegebenen Grenzwert - etwa einer bekannten Leistungsreserve der Stromversorgungseinheit NG - verglichen. Übersteigt der Summenwert diesen vorgegebenen Grenzwert, so erkennt die Steuereinheit SE daraus, dass die Stromversorgungseinheit NG ihre Leistungsfähigkeitsgrenze zumindest erreicht hat, und beginnt im Steuerschritt 105 in den Lastkreisen L1, L2, L3 den aufgenommenen Strom zumindest zu reduzieren und/oder abzuschalten.

Es kann allerdings eine kurze Zeitspanne (z.B. 5 ms) vorgegeben werden, innerhalb welcher die Stromversorgungseinheit NG zumindest geringfügig die Leistungsfähigkeitsgrenze überschreiten kann. Die Stromversorgungseinheit NG liefert dann kurzfristig einen Überstrom als Ausgangsstrom I_{A}, welcher über den normalerweise als Dauerstrom gelieferten Ausgangsstrom I_{A} hinausgeht. Wird diese vorgegebene Zeitspanne allerdings überschritten, so ist die Leistungsfähigkeitsgrenze der Stromversorgungseinheit NG zumindest erreicht und die Steuereinheit SE muss mit dem Steuerschritt 105 beginnen, um den in Lastkreisen L1, L2, L3 den aufgenommenen Strom zumindest zu reduzieren und/oder abzuschalten.

Alternativ kann beispielsweise die Steuereinheit SE aus den Stromprofilen, welche den Lastkreisen L1, L2, L3 individuell zugeordnet sind, ableiten, wie lange z.B. ein Überstrom (z.B. Einschaltstrom) andauern wird, bevor von der Steuereinheit SE im Steuerschritt 105 begonnen wird, den Strom in einem oder mehreren Lastkreisen L1, L2, L3 zu reduzieren. Einen sich daraus ergebenen Zusatzstromverbrauch kann die Steuereinheit SE mit der zeitlich begrenzten Überstromfähigkeit der Stromversorgungseinheit NG vergleichen. Ergibt sich aus diesem Vergleich, dass die Stromversorgungseinheit NG die zu erwartende Zeitdauer den notwendigen Überstrom liefern kann (d.h. die Leistungsgrenze z.B. nur geringfügig überschreitet), so wird z.B. vorerst noch nicht in die Versorgung der Lastkreise L1, L2, L3 eingegriffen. Ein Reduktion und/oder Abschaltung des Stroms in den Lastkreisen L1, L2, L3 erfolgt beispielsweise erst dann, wenn erkennbar ist, dass das signifikante Stromprofil nicht eingehalten wird.

Weiterhin kann auch die Stromversorgungseinheit NG laufend aktuelle Auslastungswerte AW an die Steuereinheit SE übertragen, welche z.B. in Form von Parametern eine aktuelle Situation, wie z.B. eine interne thermische Situation (z.B. Temperatur, Erwärmungsgrad, etc.), Eingangsspannungsschwankungen (z.B. Spannungsspitzen, Netzstörungen, Phasenausfall, etc.), etc., in der Stromversorgungseinheit NG wiedergeben. Anhand der aktuellen Auslastungswerte AW der Stromversorgungseinheit NG kann die Steuereinheit SE die aktuelle Leistungsfähigkeit der Stromversorgungseinheit NG erkennen und z.B. vorausberechnen, wann und ob die Stromversorgungseinheit NG z.B. zwecks Eigenschutz ihre Ausgangsspannung U_{A} abregeln muss bzw. ihre Leistungsfähigkeitsgrenze zumindest erreicht.

Wird von der Stromversorgungseinheit NG die Leistungsfähigkeitsgrenze zumindest erreicht oder überschritten, so beginnt die Steuereinheit SE im Steuerschritt 105 den aufgenommenen Strom in jenen Lastkreisen L1, L2, L3 zumindest zu reduzieren und/oder abzuschalten, bei welchen vom aktuell für den jeweiligen Lastkreis L1, L2, L3 gemessenen Stromverlauf i1, i2, i3 eine obere Grenze des Toleranzbereichs des dem jeweiligen Lastkreis L1, L2, L3 zugeordneten, signifikanten Stromprofils überschritten wird. Dabei werden von der Steuereinheit SE die jeweiligen Schaltereinheiten S1, S2, S3 dieser Lastkreise L1, L2, L3 mit Steuersignalen AS1, AS2, AS3 angesteuert, um den Strom im jeweiligen Lastkreis L1, L2, L3 zu reduzieren und/oder abzuschalten.

Für eine Reduktion des vom jeweiligen Lastkreis L1, L2, L3 aufgenommene Stroms kann die entsprechende Schaltereinheit S1, S2, S3 beispielsweise durch ein entsprechendes Steuersignal AS1, AS2, AS3 derart angesteuert werden, dass der vom jeweiligen Lastkreis (L1, L2, L3) aufgenommene Strom zeitlich begrenzt wird. Die Schaltereinheit S1, S2, S3 kann allerdings mittels eines entsprechenden Steuersignals AS1, AS2, AS3 in einen Taktbetrieb versetzt werden, durch welchen z.B. auf einem konstanten Wert gehalten wird. Kann durch eine Reduktion des Stroms in den toleranzüberschreitenden Lastkreisen L1, L2, L3 - d.h. Lastkreise L1, L2, L3, in denen vom aktuellen Stromverlauf i1, i2, i3 die obere Grenze des Toleranzbereichs des dem jeweiligen Lastkreis L1, L2, L3 zugeordneten, signifikanten Stromprofils überschritten wird - eine Unterschreiten der Leistungsfähigkeitsgrenze durch die Stromversorgungseinheit NG nicht erzielt werden, so können einzelne oder alle toleranzüberschreitenden Lastkreise L1, L2, L3 durch entsprechende Steuersignal AS1, AS2, AS3 der Steuereinheit SE an die jeweiligen Schaltereinheiten S1, S2, S3 auch abgeschaltet werden.

Um rasch die toleranzüberschreitenden Lastkreise L1, L2, L3 bestimmen zu können, kann von der Steuereinheit SE im Steuerschritt 105 auf die Statusmarkierungen aus dem Überwachungsschritt 103 zurückgegriffen werden. Statusmarkierungen wurden jenen Lastkreisen L1, L2, L3 im Überwachungsschritt 103 zugeordnet, bei welchen vom im Überwachungsschritt 103 aktuell gemessene Stromverlauf i1, i2, i3 die obere Grenze des Toleranzbereichs des dem jeweiligen Lastkreis L1, L2, L3 zugeordneten, signifikanten Stromprofils überschritten wurde.

Der Steuereinheit SE kann im Steuerschritt 105 außerdem eine Reihenfolge vorgegebenen werden, nach welcher der Strom in den toleranzüberschreitenden Lastkreisen L1, L2, L3 reduziert bzw. nach welcher toleranzüberschreitende Lastkreise L1, L2, L3 abgeschaltet werden. Bei dieser vorgegebenen Reihenfolge kann beispielsweise festgelegt werden, dass zuerst in jenen Lastkreise L1, L2, L3 eine Stromreduktion und/oder Stromabschaltung vorgenommen wird, welche die jeweilige obere Grenze des Toleranzbereichs des jeweils zugeordneten, signifikanten Stromprofils am stärksten überschreiten. Das bedeutet, der Strom in jenen toleranzüberschreitenden Lastkreisen L1, L2, L3, welche die Stromversorgungseinheit NG am stärksten belasten bzw. den meisten Strom aufnehmen oder am wahrscheinlichsten einen Defekt aufweisen, wird zuerst reduziert und/oder abgeschaltet.

Weiterhin besteht zusätzlich die Möglichkeit, auch in weiteren - nicht toleranzüberschreitenden - Lastkreisen L1, L2, L3 den von den jeweiligen Lastkreis L1, L2, L3 aufgenommenen Strom zu reduzieren und/oder abzuschalten, wenn z.B. die Stromreduktion und/oder -abschaltungen in den toleranzüberschreitenden Lastkreisen nicht ausreicht, die Leistungsfähigkeit der Stromversorgungseinheit NG wiederherzustellen. Die Abschaltung des jeweils aufgenommenen Stroms in den Lastkreisen L1, L2, L3 kann dabei beispielsweise nach einer vorher festgelegten Priorisierung der Lastkreise erfolgen, damit z.B. wichtige Lastkreise L1, L2, L3 bzw. daran angeschlossene, wichtige Lasteinheiten (z.B. Steuerungen, etc.) möglichst mit Energie versorgt werden und lang verfügbar bleiben.

## Patentansprüche

1. Verfahren zum Überwachen und Steuern einer Stromverteilung in Lastkreisen (L1, L2, L3) einer Anlagensteuerung einer technischen Anlage, wobei von zumindest einer getakteten Stromversorgungseinheit (NG) eine vorgegebene Ausgangsspannung (U_{A}) zur Verfügung gestellt wird, welche für eine Energieversorgung auf die Lastkreise (L1, L2, L3) aufgeteilt wird, und wobei zumindest eine Mehrzahl der Lastkreise (L1, L2, L3) durch jeweils eine Schaltereinheit (S1, S2, S3) für jeden der Lastkreise abgesichert wird, welche von einer Steuereinheit (SE) angesteuert wird, **dadurch gekennzeichnet, dass** während einer Lernphase zumindest in den mit einer Schaltereinheit (S1, S2, S3) abgesicherten Lastkreisen (L1, L2, L3) ein Stromverlauf (i1, i2, i3) des von einem jeweiligen Lastkreis (L1, L2, L3) aufgenommenen Stroms gemessen wird (101), dass aus dem für den jeweiligen Lastkreis (L1, L2, L3) gemessenen Stromverlauf (i1, i2, i3) zumindest ein signifikantes Stromprofil und ein zugehöriger Toleranzbereich abgeleitet und dem jeweiligen Lastkreis (L1, L2, L3) zugeordnet werden (102), dass während eines laufenden Betriebs der Anlage von der Steuereinheit (SE) laufend ein zumindest in den mit einer der Schaltereinheiten (S1, S2, S3) abgesicherten Lastkreisen (L1, L2, L3) aktuell gemessener Stromverlauf (i1, i2, i3) überwacht wird (103) und geprüft wird (104), ob von der getakteten Stromversorgungseinheit (NG) eine Leistungsfähigkeitsgrenze zumindest erreicht wird, und dass bei zumindest Erreichen der Leistungsfähigkeitsgrenze durch die getaktete Stromversorgungseinheit (NG) von der Steuereinheit (SE) durch Ansteuern der jeweiligen Schaltereinheit (S1, S2, S3) in jenen Lastkreisen (L1, L2, L3) der vom jeweiligen Lastkreis (L1, L2, L3) aufgenommene Strom zumindest reduziert und/oder abgeschaltet wird, bei welchen vom aktuell für den jeweiligen Lastkreis (L1, L2, L3) gemessenen Stromverlauf (i1, i2, i3) eine obere Grenze des Toleranzbereichs des dem jeweiligen Lastkreis (L1, L2, L3) zugeordneten Stromprofils überschritten wird.

2. Verfahren nach Anspruch 1, ***dadurch gekennzeichnet, dass*** zum Erkennen eines Erreichens der Leistungsfähigkeitsgrenze der getakteten Stromversorgungseinheit (NG) von der Steuereinheit (SE) die Ausgangsspannung (UA) der getakteten Stromversorgungseinheit (NG) oder eine Summe aktueller Strommesswerte der von den Lastkreisen (L1, L2, L3) jeweils aufgenommenen Ströme überwacht wird (104).

3. Verfahren nach eine der Ansprüche 1 bis 2, ***dadurch gekennzeichnet, dass*** eine Zeitspanne vorgegeben wird, während welcher die Leistungsfähigkeitsgrenze der getakteten Stromversorgungseinheit (NG) um eine vorgegebene Höhe überschritten werden kann.

4. Verfahren nach einem der vorangegangenen Ansprüche, ***dadurch gekennzeichnet, dass*** zum Erkennen des Erreichens der Leistungsfähigkeitsgrenze der getakteten Stromversorgungseinheit (NG) von der getakteten Stromversorgungeinheit (NG) laufend aktuelle Auslastungswerte (AW) oder ein Erreichen und/oder Überschreiten der Leistungsfähigkeitsgrenze an die Steuereinheit (SE) übertragen werden (104).

5. Verfahren nach einem der vorangegangenen Ansprüche, ***dadurch gekennzeichnet, dass*** der Steuereinheit (SE) eine Reihenfolge für eine Reduktion und/oder eine Abschaltung des Stroms in jenen Lastkreisen (L1, L2, L3) vorgegeben wird (105), bei welchen vom aktuell für den jeweiligen Lastkreis gemessenen Stromverlauf (i1, i2, i3) die obere Grenze des Toleranzbereichs des dem jeweiligen Lastkreis (L1, L2, L3) zugeordneten, signifikanten Stromprofils überschritten wird.

6. Verfahren nach einem der vorangegangenen Ansprüche, ***dadurch gekennzeichnet, dass*** jenen Lastkreisen (L1, L2, L3) eine Statusmarkierung zugeordnet wird (103), bei welchen vom aktuell für den jeweiligen Lastkreis (L1, L2, L3) gemessenen Stromverlauf (i1, i2, i3) im laufenden Betrieb der Anlage die obere Grenze des Toleranzbereichs des dem jeweiligen Lastkreis (L1, L2, L3) zugeordneten, signifikanten Stromprofils überschritten wird.

7. Verfahren nach Anspruch 6, ***dadurch gekennzeichnet, dass*** bei Erreichen der Leistungsfähigkeitsgrenze durch die getaktete Stromversorgungseinheit (NG) von der Steuereinheit (SE) die dem jeweiligen Lastkreis (L1, L2, L3) aktuell zugeordnete Statusmarkierung herangezogen wird (105).

8. Verfahren nach einem der vorangegangenen Ansprüche, ***dadurch gekennzeichnet, dass*** für jene Lastkreise (L1, L2, L3) eine Alarmmeldung ausgegeben wird (103), bei welchen vom aktuell für den jeweiligen Lastkreis (L1, L2, L3) gemessenen Stromverlauf (i1, i2, i3) im laufenden Betrieb der Anlage die obere Grenze des Toleranzbereichs des dem jeweiligen Lastkreis (L1, L2, L3) zugeordneten, signifikanten Stromprofils überschritten wird.

9. Verfahren nach einem der vorangegangenen Ansprüche, ***dadurch gekennzeichnet, dass*** für die Reduktion des vom jeweiligen Lastkreis (L1, L2, L3) aufgenommenen Stroms die Schaltereinheit (S1, S2, S3) des jeweiligen Lastkreises (L1, L2, L3) von der Steuereinheit (SE) derart angesteuert wird (105), dass der vom jeweiligen Lastkreis (L1, L2, L3) aufgenommene Strom zeitlich begrenzt wird und/oder die Schaltereinheit (S1, S2, S3) in einen Taktbetrieb geschaltet wird.

10. Verfahren nach einem der vorangegangenen Ansprüche, ***dadurch gekennzeichnet, dass*** das signifikante Stromprofil des jeweiligen Lastkreises (L1, L2, L3) anhand von Vorgabedaten (VD) aus dem für den jeweiligen Lastkreis (L1, L2, L3) gemessenen Stromverlauf (i1, i2, i3) abgeleitet wird (102).

11. Verfahren nach einem der vorangegangenen Ansprüche, ***dadurch gekennzeichnet, dass*** für eine Ableitung des signifikanten Stromprofils des jeweiligen Lastkreises (L1, L2, L3) ein trainiertes, neuronales Netz verwendet wird (102).

12. Verfahren nach einem der vorangegangenen Ansprüche, ***dadurch gekennzeichnet, dass*** für die Lernphase eine Mindestdauer vorgegeben wird.

13. Verfahren nach einem der vorangegangenen Ansprüche, ***dadurch gekennzeichnet, dass*** weiterhin für jeden mit einer Schaltereinheit abgesicherten Lastkreis (L1, L2, L3) ein Sicherheitsgrenzwert vorgegeben wird, bei dessen Erreichen und/oder Überschreiten der vom jeweiligen Lastkreis (L1, L2, L3) aufgenommene Strom immer abgeschaltet wird.

14. Verfahren nach einem der vorangegangenen Ansprüche, ***dadurch gekennzeichnet, dass*** in den Lastkreisen (L1, L2, L3) eine zusätzliche Schutzeinrichtung vorgesehen wird.

15. Verfahren nach einem der vorangegangenen Ansprüche, ***dadurch gekennzeichnet, dass*** als Schaltereinheit (S1, S2, S3) ein Leistungstransistor oder ein Mikro-Elektronisch-Mechanisches-System, kurz MEMS, eingesetzt wird.

## Claims

1. Method for monitoring and controlling a current distribution in load circuits (L1, L2, L3) of an installation control system of a technical installation, wherein a predetermined output voltage (U_{A}) is made available by at least one clocked power supply unit (NG) and distributed for an energy supply to the load circuits (L1, L2, L3), and wherein at least a plurality of the load circuits (L1, L2, L3) are protected by a switch unit (S1, S2, S3) in each case for each of the load circuits, which is actuated by a control unit (SE), **characterised in that** during a learning phase, at least in the load circuits (L1, L2, L3) which are protected with a switch unit (S1, S2, S3), a current variation (i1, i2, i3) of the current consumed by each load circuit (L1, L2, L3) is measured (101), **in that** from the current variation (i1, i2, i3) measured for the respective load circuit (L1, L2, L3) at least a significant current profile and an associated tolerance range is derived and associated (102) with the respective load circuit (L1, L2, L3), **in that** during an ongoing operation of the installation, a current variation (i1, i2, i3) which is presently being measured at least in the load circuits (L1, L2, L3) which are protected with one of the switch units (S1, S2, S3) is continuously monitored (103) by the control unit (SE) and it is checked (104) whether a power capacity limit is at least reached by the clocked power supply unit (NG), and if the power capacity limit is at least reached by the clocked power supply unit (NG), the current consumed by each load circuit (L1, L2, L3) is at least reduced and/or switched off by the control unit (SE) by actuating the respective switch unit (S1, S2, S3) in those load circuits (L1, L2, L3), in which an upper limit of the tolerance range of the current profile associated with the respective load circuit (L1, L2, L3) is exceeded by the current variation (i1, i2, i3) presently being measured for the respective load circuit (L1, L2, L3).

2. Method according to claim 1, ***characterised in that*** in order to recognise a reaching of the power capacity limit of the clocked power supply unit (NG), the output voltage (UA) of the clocked power supply unit (NG) or a sum of prevailing current measurement values of the respective currents consumed by the load circuits (L1, L2, L3) is monitored (104) by the control unit (SE).

3. Method according to one of claims 1 to 2, ***characterised in that*** a timespan is predetermined during which the power capacity limit of the clocked power supply unit (NG) can be exceeded by a predetermined amount.

4. Method according to one of the preceding claims, ***characterised in that*** in order to recognise the reaching of the power capacity limit of the clocked power supply unit (NG), prevailing capacity utilisation values (AW) or a reaching and/or exceeding of the power capacity limit are continuously transferred (104) from the clocked power supply unit (NG) to the control unit (SE).

5. Method according to one of the preceding claims, ***characterised in that*** a sequence is specified (105) to the control unit (SE) for a reduction and/or a switching-off of the current in those load circuits (L1, L2, L3) in which the upper limit of the tolerance range of the significant current profile associated with the respective load circuit (L1, L2, L3) is exceeded by the current variation (i1, i2, i3) presently being measured for the respective load circuit.

6. Method according to one of the preceding claims, ***characterised in that*** a status marking is assigned (103) to those load circuits (L1, L2, L3) in which the upper limit of the tolerance range of the significant current profile associated with the respective load circuit (L1, L2, L3) is exceeded, during ongoing operation of the installation, by the current variation (i1, i2, i3) presently being measured for the respective load circuit (L1, L2, L3).

7. Method according to claim 6, ***characterised in that*** on reaching the power capacity limit by the clocked power supply unit (NG), the status marking that is currently assigned to the respective load circuit (L1, L2, L3) is used (105) by the control unit (SE).

8. Method according to one of the preceding claims, ***characterised in that*** an alarm message is output (103) for those load circuits (L1, L2, L3) in which the upper limit of the tolerance range of the significant current profile associated with the respective load circuit (L1, L2, L3) is exceeded, during ongoing operation of the installation, by the current variation (i1, i2, i3) presently being measured for the respective load circuit (L1, L2, L3).

9. Method according to one of the preceding claims, ***characterised in that*** for the reduction of the current consumed by the respective load circuit (L1, L2, L3), the switch unit (S1, S2, S3) of the respective load circuit (L1, L2, L3) is actuated (105) by the control unit (SE) such that the current consumed by the respective load circuit (L1, L2, L3) is time-limited and/or the switch unit (S1, S2, S3) is switched into a clocked operation.

10. Method according to one of the preceding claims, ***characterised in that*** the significant current profile of the respective load circuit (L1, L2, L3) is derived (102) from the current variation (i1, i2, i3) measured for the respective load circuit (L1, L2, L3) on the basis of preset data (VD).

11. Method according to one of the preceding claims, ***characterised in that*** a trained neural network is used (102) for a derivation of the significant current profile of the respective load circuit (L1, L2, L3).

12. Method according to one of the preceding claims, ***characterised in that*** a minimum duration is specified for the learning phase.

13. Method according to one of the preceding claims, ***characterised in that*** furthermore for each load circuit (L1, L2, L3) protected with a switch unit, a safety limit value is defined, on reaching and/or exceeding which the current consumed by the respective load circuit (L1, L2, L3) is always switched off.

14. Method according to one of the preceding claims, ***characterised in that*** an additional protection apparatus is provided in the load circuits (L1, L2, L3).

15. Method according to one of the preceding claims, ***characterised in that*** a power transistor or a microelectromechanical system, MEMS for short, is used as the switch unit (S1, S2, S3).

## Revendications

1. Procédé de surveillance et de commande d'une distribution de courant dans des circuits de charge (L1, L2, L3) d'une commande d'installation d'une installation technique, dans lequel au moins une unité d'alimentation électrique cadencée (NG) met à disposition une tension de sortie prédéfinie (U_{A}) qui est répartie entre les circuits de charge (L1, L2, L3) pour une alimentation en énergie, et dans lequel au moins une pluralité des circuits de charge (L1, L2, L3) est protégée par une unité de commutation (S1, S2, S3) respective pour chacun des circuits de charge, qui est commandée par une unité de commande (SE), **caractérisé en ce que,** pendant une phase d'apprentissage, au moins dans les circuits de charge (L1, L2, L3) protégés par une unité de commutation (S1, S2, S3), une courbe de courant (i1, i2, i3) du courant absorbé par un circuit de charge (L1, L2, L3) respectif est mesurée (101), au moins un profil de courant significatif et une plage de tolérance correspondante sont déduits de la courbe de courant (i1, i2, i3) mesurée pour le circuit de charge (L1, L2, L3) respectif et sont attribués (102) au circuit de charge (L1, L2, L3) respectif, **en ce que**, pendant le fonctionnement de l'installation, l'unité de commande (SE) surveille (103) au moins une courbe de courant (i1, i2, i3) mesurée actuellement dans les circuits de charge (L1, L2, L3) protégés par l'une des unités de commutation (S1, S2, S3), et vérifie (104) si une limite de puissance de l'unité d'alimentation électrique cadencée (NG) est au moins atteinte, et **en ce qu'**au moins, lorsque la limite de puissance est au moins atteinte par l'unité d'alimentation électrique cadencée (NG) de l'unité de commande (SE), le courant absorbé par le circuit de charge (L1, L2, L3) correspondant est au moins réduit et/ou coupé par la commande de l'unité de commutation (S1, S2, S3) correspondante dans les circuits de charge (L1, L2, L3) concernés, dans lesquels une limite supérieure de la plage de tolérance du profil de courant attribué au circuit de charge (L1, L2, L3) respectif est dépassée par la courbe de courant (i1, i2, i3) actuellement mesurée pour le circuit de charge (L1, L2, L3) respectif.

2. Procédé selon la revendication 1, **caractérisé en ce que,** pour détecter que la limite de puissance de l'unité d'alimentation électrique cadencée (NG) est atteinte, l'unité de commande (SE) surveille (104) la tension de sortie (UA) de l'unité d'alimentation électrique cadencée (NG) ou une somme des valeurs de courant actuelles mesurées pour les courants absorbés respectivement par les circuits de charge (L1, L2, L3).

3. Procédé selon l'une des revendications 1 à 2, **caractérisé en ce qu'**une durée est prédéfinie pendant laquelle la limite de puissance de l'unité d'alimentation électrique cadencée (NG) peut être dépassée d'une valeur prédéfinie.

4. Procédé selon l'une des revendications précédentes, **caractérisé en ce que,** pour détecter que la limite de puissance de l'unité d'alimentation électrique cadencée (NG) est atteinte, les valeurs d'utilisation actuelles (AW) de l'unité d'alimentation électrique cadencée (NG) ou le fait que la limite de puissance est atteinte et/ou dépassée sont transmis (104) en continu à l'unité de commande (SE).

5. Procédé selon l'une des revendications précédentes, **caractérisé en ce que** l'unité de commande (SE) prédéfinit (105) une séquence pour une réduction et/ou une coupure du courant dans les circuits de charge (L1, L2, L3) dans lesquels la courbe de courant (i1, i2, i3) dépasse la limite supérieure de la plage de tolérance du profil de courant significatif attribué au circuit de charge (L1, L2, L3) respectif.

6. Procédé selon l'une des revendications précédentes, **caractérisé en ce qu'**un marqueur d'état est attribué (103) aux circuits de charge (L1, L2, L3) pour lesquels la courbe de courant (i1, i2, i3) actuellement mesurée pour le circuit de charge (L1, L2, L3) respectif dépasse la limite supérieure de la plage de tolérance du profil de courant significatif attribué au circuit de charge (L1, L2, L3) respectif.

7. Procédé selon la revendication 6, **caractérisé en ce que,** lorsque la limite de puissance est atteinte par l'unité d'alimentation électrique cadencée (NG) de l'unité de commande (SE), le marqueur d'état actuellement attribué au circuit de charge (L1, L2, L3) correspondant est utilisé (105).

8. Procédé selon l'une des revendications précédentes, **caractérisé en ce qu'**un message d'alarme est émis (103) pour les circuits de charge (L1, L2, L3) pour lesquels la courbe de courant (i1, i2, i3) mesurée actuellement pour le circuit de charge (L1, L2, L3) respectif dépasse la limite supérieure de la plage de tolérance du profil de courant significatif attribué au circuit de charge (L1, L2, L3) respectif pendant le fonctionnement de l'installation.

9. Procédé selon l'une des revendications précédentes, **caractérisé en ce que,** pour la réduction du courant absorbé par le circuit de charge (L1, L2, L3) respectif, l'unité de commutation (S1, S2, S3) du circuit de charge (L1, L2, L3) respectif est commandée (105) par l'unité de commande (SE) de telle sorte que le courant absorbé par le circuit de charge (L1, L2, L3) respectif soit limité dans le temps et/ou que l'unité de commutation (S1, S2, S3) soit commutée en mode de fonctionnement cadencé.

10. Procédé selon l'une des revendications précédentes, **caractérisé en ce que** le profil de courant significatif du circuit de charge (L1, L2, L3) respectif est déduit (102) à partir de données de référence (VD) issues de la courbe de courant (i1, i2, i3) mesurée par le circuit de charge (L1, L2, L3) respectif.

11. Procédé selon l'une des revendications précédentes, **caractérisé en ce qu'**un réseau neuronal entraîné est utilisé (102) pour déduire le profil de courant significatif du circuit de charge (L1, L2, L3) respectif.

12. Procédé selon l'une des revendications précédentes, **caractérisé en ce qu'**une durée minimale est fixée pour la phase d'apprentissage.

13. Procédé selon l'une des revendications précédentes, **caractérisé en ce qu'**une valeur limite de sécurité continue d'être prédéfinie pour chaque circuit de charge (L1, L2, L3) protégé par une unité de commutation, valeur à laquelle, lorsqu'elle est atteinte et/ou dépassée, le courant absorbé par le circuit de charge (L1, L2, L3) correspondant est toujours coupé.

14. Procédé selon l'une des revendications précédentes, **caractérisé en ce qu'**un dispositif de protection supplémentaire est prévu dans les circuits de charge (L1, L2, L3).

15. Procédé selon l'une des revendications précédentes, **caractérisé en ce qu'**un transistor de puissance ou un microsystème électromécanique (MEMS) est utilisé comme unité de commutation (S1, S2, S3).
